# EUROPÄISCHE PATENTSCHRIFT

(11) **EP 1 842 246 B1**
(45) Veröffentlichungstag und Bekanntmachung des Hinweises auf die Patenterteilung: **07.03.2012**
(21) Anmeldenummer: 06705850.3
(22) Anmeldetag: 25.01.2006
(51) Int. Cl.: H01L 41/047, H01L 41/083

(54) **PIEZOELEKTRISCHES BAUELEMENT**
PIEZOELECTRIC COMPONENT
COMPOSANT PIEZOELECTRIQUE

(30) Priorität: 26.01.2005 DE 102005003693; 13.04.2005 DE 102005017108
(43) Veröffentlichungstag der Anmeldung: 10.10.2007
(73) Patentinhaber: EPCOS AG, 81669 München (DE)
(72) Erfinder: FLORIAN, Heinz, A-8524 Bad Gams (AT); KARTASHEV, Igor, A-8530 Deutschlandsberg (AT); REICHMANN, Klaus, A-8042 Graz (AT); VOGL, Wolfgang, A-1160 Wien (AT)
(74) Vertreter: Epping - Hermann - Fischer
(86) Internationale Anmeldenummer: PCT/DE2006/000114
(87) Internationale Veröffentlichungsnummer: WO 2006/079324

(56) Entgegenhaltungen:
- EP-A- 0 844 678
- EP-A- 1 257 006
- EP-A- 1 329 915
- WO-A-03/094252
- WO-A2-2005/104256
- DE-A1-102004 005 528
- DE-A1-102004 015 574
- US-B1- 6 333 589

## Beschreibung

Es wird ein piezoelektrisches Vielschicht-Bauelement angegeben.

Aus der Druckschrift WO 03/094252 A2 ist ein Piezoaktor bekannt, der in einem Mehrschichtaufbau Piezolagen und zwischen diesen Lagen angeordnete Innenelektroden enthält, die von stiftförmigen Kontaktelementen Kontaktiert werden.

Aus den Druckschriften EP 0 844 678 A1 und EP 1 329. 915 A1 geht jeweils ein elektrisches Vielschicht-Bauelement hervor, bei dem eine flächige Außere elektrode als Metallschaum ausgebildet ist.

Eine zu lösende Aufgabe besteht darin, ein piezoelektrisches Vielschicht-Bauelement bereitzustellen, das einer hohen mechanischen und elektrischen Belastung standhalten kann.

Ein hier beschriebenes piezoelektrisches Vielschicht-Bauelement kann beispielsweise als ein piezokeramisches Bauteil mit einem keramischen Grundkörper, darin angeordneten strukturierten Metalllagen und Außenkontakten ausgebildet sein. Es können elektromechanische Deformationen des Grundkörpers vorkommen, die zu mechanischen Spannungen zwischen keramischen Schichten und Metallschichten führen und die zur Rissbildung in Metallstrukturen mit einhergehender Kontaktunterbrechung bis zur Ablösung der Metallisierung führen können.

Es wird ein Vielschicht-Bauelement mit mindestens zwei, jeweils durch eine dielektrische Schicht voneinander getrennten Metalllagen angegeben, die durch ein stiftförmiges Kontaktelement enthaltend einen porösen Körper elektrisch miteinander verbunden sind.

Ein poröses Material ist besonders gut geeignet, um mechanische Schwingungen zu dämpfen. In einem porösen Körper wird die Ausbreitung akustischer Wellen weitgehend unterbunden.

Die Porosität des Körpers kann z. B. mehr als 10%, in einer vorteilhaften Variante mehr als 20% betragen. Unter der Porosität eines Körpers versteht man das Verhältnis des Volumens der vorhandenen Hohlräume zum Gesamtvolumen des Körpers. -

Die Porengröße wird z. B. durch die Korngröße eines Materials bestimmt, das zur Herstellung des porösen Körpers verwendet wird, und kann beispielsweise zwischen 0,1 bis 100 µm, in einer Variante hauptsächlich zwischen 0,1 und 10 µm liegen.

In einer bevorzugten Variante wird ein piezoelektrisches Bauelement mit einem Grundkörper angegeben, der einen Stapel von übereinanderliegenden piezoelektrischen Schichten und dazwischen liegenden Elektrodenschichten enthält. In den Elektrodenschichten ist jeweils mindestens eine Innenelektrode ausgebildet. Senkrecht zu den Innenelektroden verläuft ein diese kontaktierendes elektrisch leitendes Kontaktelement, das ein poröses Material enthält.

Das piezoelektrische Vielschicht-Bauelement ist vorzugsweise ein piezokeramisches Piezoaktor oder Piezotransformator.

Das angegebene Vielschicht-Bauelement zeichnet sich durch eine hohe Zuverlässigkeit und Zyklenfestigkeit aus, da im porösen Material des Kontaktelements Rissbildung unterdrückt wird. Ein entstehender Riss trifft auf eine Pore und wird dadurch gestoppt. Darüber hinaus wird im Laufe der Zeit durch die Bildung vieler kleiner Risse die mechanische Spannung an der Grenzfläche zwischen Keramik und Metallisierung effektiv abgebaut, ohne die elektrische Anbindung zu beeinträchtigen.

Die piezoelektrischen Schichten enthalten vorzugsweise Keramikmaterial und sind miteinander und mit den Elektrodenschichten versintert. Vorzugsweise sind übereinander in abwechselnder Reihenfolge angeordnete erste und zweite Innenelektroden vorgesehen. Die ersten Innenelektroden sind jeweils mit einem ersten Kontaktelement kontaktiert und von einem zweiten Kontaktelement isoliert. Die zweiten Innenelektroden sind umgekehrt jeweils mit dem zweiten Kontaktelement kontaktiert und vom ersten Kontaktelement isoliert.

Das Kontaktelement ist in Form eines Stiftes ausgebildet. Der Stift kann in einer Variante aus einem porösen Material bestehen. Der Stift kann alternativ einen porösen Körper aufweisen, auf den eine elektrisch leitfähige Schicht aufgetragen ist. Die elektrisch leitfähige Schicht kann z. B. in Form einer bindemittelhaltigen und vorzugsweise silber- und/oder kupferhaltigen Metallpaste auf den porösen Körper aufgetragen werden. Der Stift wird in dieser Variante in eine dafür vorgesehene Ausnehmung oder Öffnung des Bauelement-Grundkörpers eingeschoben und zusammen mit den piezoelektrischen Schichten und Elektrodenschichten versintert. Beim Sintern wird die Metallpaste in den Grundkörper eingebrannt, wobei eine feste Verbindung zwischen dem Stift und dem Grundkörper zustande kommt.

Der poröse Körper kann in einer Variante elektrisch leitfähig, z. B. als Metallschwamm vorhanden sein. Ein elektrisch leitendes poröses Material kann in einer weiteren Variante organisch sein.

In einer vorteilhaften Variante ist im porösen Körper ein massiver Stift aus einem elektrisch leitenden Material, vorzugsweise einem Metall angeordnet.

Am massiven Stift können auch mehrere übereinander angeordnete und durch einen Luftspalt voneinander getrennte poröse Körper befestigt sein. Das Material der porösen Körper ist vorzugsweise elektrisch leitfähig.

An einer Stirnseite des porösen Körpers des Kontaktelements kann eine Kontaktkappe aus einem elektrisch leitenden Material vorgesehen sein. Das elektrisch leitende Material der Kontaktkappe ist in einer Variante lötbar. Die Kontaktkappe kann Lot enthalten oder mit einer Lotschicht bedeckt sein. Die Kontaktkappe kann aus einer Metallfolie gebildet sein, die das Ende des stiftartigen Kontaktelements bzw. das Ende des porösen Körpers umpresst.

Es ist möglich, das Kontaktelement nur teilweise im Grundkörper zu versenken. In diesem Fall ist an einer Seite des Grundkörpers eine Ausnehmung zur Aufnahme des Kontaktelements ausgebildet. Ein Teil des Kontaktelements passt vorzugsweise formschlüssig in diese Ausnehmung hinein und wird darin z. B. mittels eines Haftvermittlers befestigt. Der Haftvermittler stellt vorzugsweise eine elektrisch leitende Schicht dar. Der Haftvermittler kann organische Komponenten enthalten.

In einer weiteren Ausführung ist es möglich, das Kontaktelement größtenteils im Inneren des Grundkörpers anzuordnen, wobei die Mantelfläche des Kontaktelements im Querschnitt quer zur Ausrichtung des Kontaktelements vorzugsweise allseitig durch den Grundkörper umgeben ist. Im Grundkörperinneren ist eine Öffnung zur Aufnahme des Kontaktelements ausgebildet.

Das poröse Material kann offenporig sein, d. h. die meisten seiner Poren sind miteinander verbunden.

Der poröse Körper kann aus einem anorganischen, in einer Variante elektrisch nicht leitfähigen Material wie z. B. Keramik sein, dessen Oberfläche mit einer elektrisch leitfähigen Schicht versehen ist. Die elektrisch leitfähige Schicht ist vorzugsweise eine Metallschicht.

Das elektrisch leitende poröse Material kann in einer weiteren Variante aus einem organischen Material gebildet sein, dessen Oberfläche mit einer elektrisch leitfähigen Schicht z. B. aus Metall versehen ist.

Das Kontaktelement ist vorzugsweise parallel zur piezoelektrischen Achse ausgerichtet. Es ist vorteilhaft, das Kontaktelement an einer Stelle des Grundkörpers anzuordnen, an der die geringsten mechanischen Verspannungen auftreten. Dies kann beispielsweise im Mittelbereich des Grundkörpers der Fall sein. Das Kontaktelement kann daher in einer Variante im Grundkörperinneren zentrisch angeordnet sein.

Das im Grundkörperinneren zentrisch angeordnete Kontaktelement kann einen Metallstift und mehrere an diesem befestigte und mit dem Metallstift elektrisch verbundene Segmente eines leitfähigen porösen Materials aufweisen. Diese Segmente sind vorzugsweise in axialer Richtung voneinander beabstandet. In einer Variante ist es auch möglich, mehrere in Umlaufrichtung voneinander beabstandete Segmente eines porösen Materials an einem Stift zu befestigen.

Das Kontaktelement kann in einer ersten Ausführungsform der Erfindung vor dem Entkohlen und vor dem Sintern in den Schichtstapel eingeschoben werden. Dann ist es vorteilhaft, die Abmessungen des Lochs so auf die Abmessungen des Kontaktelements abzustimmen, dass nach dem Sintern des Schichtstapels durch den Schrumpf der in den piezoelektrischen Schichten enthaltenen Keramik diese gewissermaßen auf das Kontaktelement aufschrumpft und somit die elektrische Kontaktierung des Kontaktelements mit Elektrodenschichten ermöglicht.

Es ist dabei im weiteren vorteilhaft, wenn das Kontaktelement wenigstens auf seiner Oberfläche zu wenigstens 50 % aus demselben Material besteht, aus dem auch die Elektrodenschichten gebildet sind. Dies gewährleistet eine relativ gute chemische Anbindung des Kontaktelements an die Elektrodenschichten, was den elektrischen Kontakt zwischen dem Kontaktelement und Elektrodenschichten verbessert.

Durch geeignete Abmessungen von Loch und Kontaktelement sowie aufschrumpfen des Keramikmaterials auf das Kontaktelement kann somit eine formschlüssige bzw. kraftschlüssige Verbindung zwischen dem Kontaktelement und dem Grundkörper hergestellt werden. Eine formschlüssige Verbindung ist vorteilhaft für die Herstellung des elektrischen Kontakts zwischen dem Kontaktelement und den Elektrodenschichten.

In einer weiteren Ausführungsform der Erfindung kann das Kontaktelement bzw. die Bildung des Lochs nach dem Entkohlen und Sintern des Schichtstapels durchgeführt werden. In diesem Fall, wenn also das Kontaktelement wiederum zur Kontaktierung der Elektrodenschichten verwendet werden soll, ist es vorteilhaft, wenn die Abmessungen des Lochs und des Kontaktelements so aufeinander abgestimmt sind, dass im gesinterten Zustand des Schichtstapels das Kontaktelement noch durch das Loch geschoben werden kann, also ein gewisser Mindestspielraum zwischen der Innenwand des Schichtstapels und der Außenwand des Kontaktelements vorhanden ist. Um zu einer sicheren Kontaktierung zu kommen, ist es dann vorteilhaft, beispielsweise das Kontaktelement auf seiner Außenseite mit Graphit oder einem anderen elektrisch leitfähigen Gleitmittel zu versehen, welches es ermöglicht, die zum Einschieben des Kontaktelements benötigten Zwischenräume aufzufüllen und für eine gute Kontaktierung zwischen dem Kontaktelement und den Elektrodenschicht zu sorgen.

Im folgenden wird die Erfindung anhand von Ausführungsbeispielen und der dazugehörigen Figuren näher erläutert. Die Figuren zeigen anhand schematischer und nicht maßstabsgetreuer Darstellungen verschiedene Ausführungsbeispiele der Erfindung. Gleiche oder gleich wirkende Teile sind mit gleichen Bezugszeichen bezeichnet. Es zeigen schematisch
Figur 1A ein piezoelektrisches Vielschicht-Bauelement mit im Grundkörper teilweise versenkten Kontaktelementen aus einem porösen Material;
Figur 1B eine Draufsicht auf eine Metalllage des Bauelements gemäß Figur 1A;
Figur 1C eine perspektivische Ansicht des Bauelements gemäß Figur 1A;
Figur 2A ein piezoelektrisches Vielschicht-Bauelement mit im Grundkörper angeordneten Kontaktelementen aus einem porösen Material;
Figur 2B eine Draufsicht auf eine Metalllage des Bauelements gemäß Figur 2A;
Figur 2C eine perspektivische Ansicht des Bauelements gemäß Figur 2A;
Figur 3A im Querschnitt ein Kontaktelement aus einem porösen Material;
Figur 3B im Querschnitt ein Kontaktelement mit einem porösen Körper und einer elektrisch leitfähigen Schicht;
Figur 4 im Querschnitt ein Kontaktelement mit einem porösen Körper und einem darin angeordneten Stift;
Figur 5 im Querschnitt ein Kontaktelement mit mehreren porösen Körpern, die an einem Stift befestigt sind.

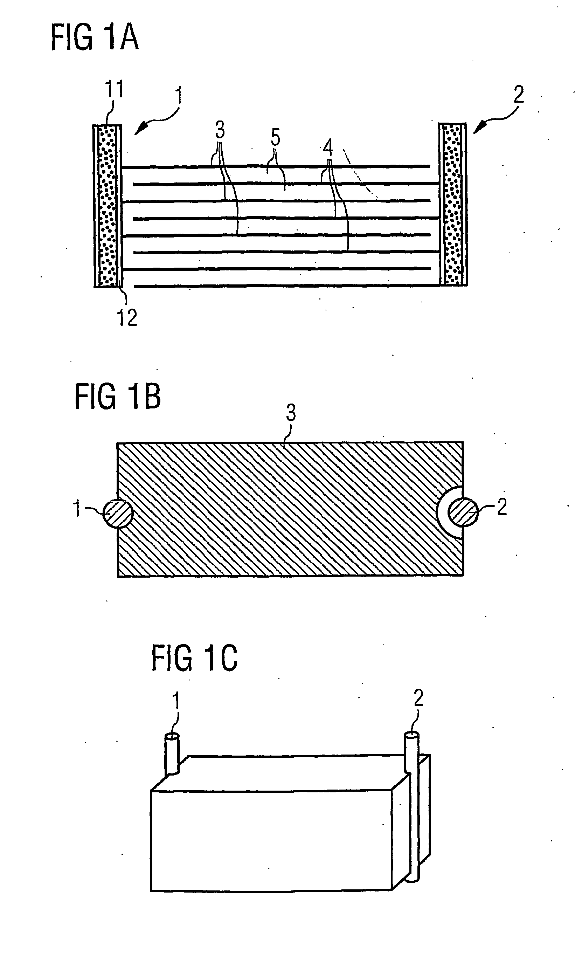

Figur 1A zeigt ausschnittsweise einen schematisch Querschnitt eines piezoelektrischen Vielschicht-Bauelements. Das Bauelement weist übereinander angeordnete Elektrodenschichten mit darin strukturierten ersten Innenelektroden 3 und zweiten Innenelektroden 4 auf. Zwischen den Elektrodenschichten sind dielektrische Lagen 5, vorzugsweise Keramikschichten angeordnet.

Die Innenelektroden 3, 4 sind wechselseitig mit Kontaktelementen 1, 2 kontaktiert. Die jeweils zusammengehörigen Innenelektroden - erste Elektrodenschichten 3 bzw. zweite Elektrodenschichten 4 - sind mittels des zu den jeweils anderen Innenelektroden isoliert angeordneten Kontaktelements 1 bzw. 2 elektrisch miteinander verbunden. Die Kontaktelemente 1, 2 verlaufen quer zu den Hauptflächen der Innenelektroden.

Die Kontaktelemente 1, 2 enthalten jeweils einen porösen Körper 11. Auf die Oberfläche bzw. Mantelfläche des porösen Körpers 11 ist eine elektrisch leitfähige Schicht 12 aufgebracht.

In Figur 1B ist eine strukturierte Elektrodenschicht mit einer darin ausgebildeten ersten Innenelektrode 3 gezeigt. Die erste Innenelektrode 3 ist links an das erste Kontaktelement 1 angeschlossen und weist rechts eine Aussparung auf, durch die sie vom zweiten Kontaktelement 2 elektrisch isoliert ist.

Das Bauelement gemäß Figur 1A ist in einer perspektivischen Ansicht von der Seite in Figur 1C gezeigt. An zwei gegenüber liegenden Außenseiten des Grundkörpers ist jeweils eine in axialer Richtung verlaufende Vertiefung in Form einer Rille ausgebildet.

Die einen porösen Körper aufweisende Kontaktelemente 1, 2 werden vorzugsweise vor dem Sintern des Grundkörpers vorgeformt. Die Mantelfläche des porösen Körpers und/oder die Oberfläche der dafür vorgesehenen Vertiefung wird mit einer haftvermittelnden Schicht, z. B. einer Metallpaste bedeckt und das Kontaktelement in die Vertiefung hineingelegt. Der Grundkörper wird dann zusammen mit dem Kontaktelement gesintert.

In der in Figuren 1A bis 1C gezeigten Variante ist das Kontaktelement im Querschnitt nur teilweise durch den Grundkörper umgeben.

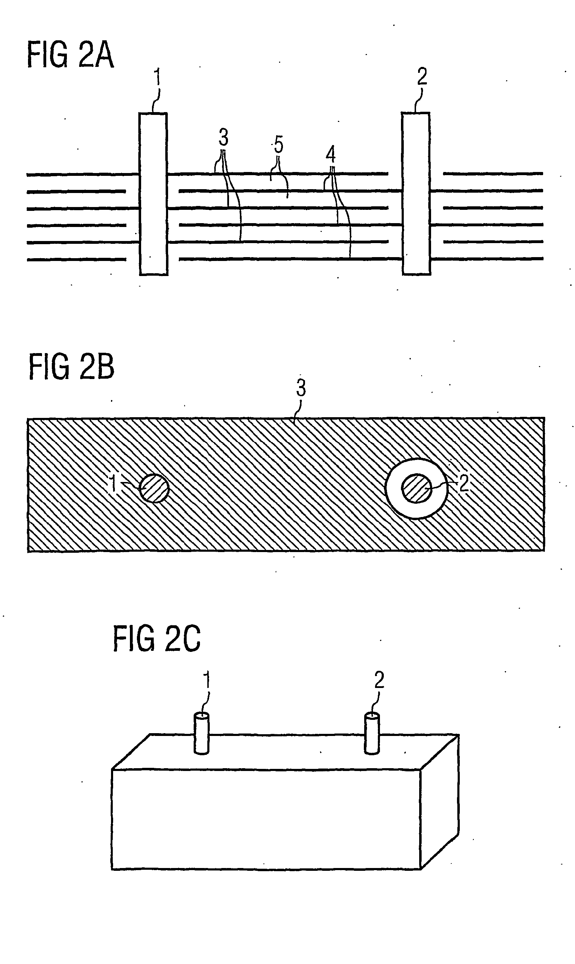

In der in Figuren 2A bis 2C gezeigten weiteren Variante eines piezoelektrisches Vielschicht-Bauelements sind die Kontaktelemente 1, 2 jeweils im Grundkörper angeordnet, so dass das Kontaktelement im Querschnitt allseitig durch den Grundkörper umgeben ist.

In Grundkörper ist quer zu den Elektrodenschichten eine Öffnung ausgebildet, in die das in Form eines Stiftes vorgeformte Kontaktelement eingeschoben ist.

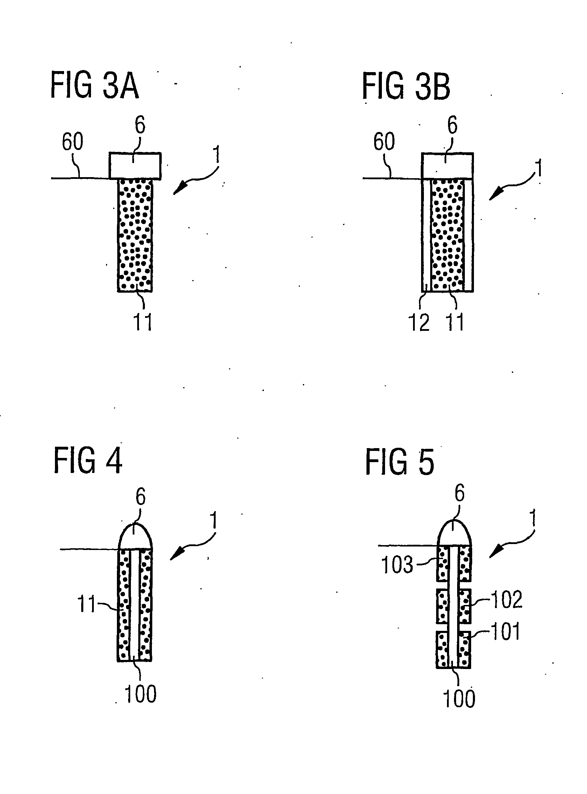

In Figuren 3A, 3B, 4 und 5 sind verschiedene Varianten eines Kontaktelements gezeigt. Es bestehen jedoch auch weitere Möglichkeiten zur Ausbildung eines Kontaktelements, das einen porösen Körper umfasst.

In Figur 3A ist ein Kontaktelement 1 mit einem porösen Körper 10 gezeigt. Das Kontaktelement 1 besteht in dieser Variante aus einem porösen Körper.

Der poröse Körper 10 ist vorzugsweise zylindrisch, kann aber im Prinzip ein poröser Stift mit einem beliebigen Querschnitt sein. Auf ein Ende des porösen Körpers 10 ist eine elektrisch leitende Kappe 6 gestülpt, die zu einer weiteren Kontaktierung des Bauelements z. B. mit einer Zuleitung 60 dient. Die Zuleitung 60 ist beispielsweise ein elektrischer Draht.

In Figur 3B ist ein Kontaktelement 1 mit einem porösen Körper 11 gemäß Figur 3A gezeigt, dessen Mantelfläche durch eine elektrisch leitfähige Schicht 12 bedeckt ist.

In Figur 4 ist ein Kontaktelement 1 mit einem porösen Körper 11 gezeigt, in dem ein vorzugsweise elektrisch leitender Stift 100 verläuft. Der Stift 100 ist in dieser Variante ein vorzugsweise massiver Trägerstift, der den porösen Körper 11 trägt.

Figur 5 zeigt eine Variante des in Figur 4 gezeigten Ausführungsbeispiels. Hier sind am Stift 100 mehrere poröse Körper 101, 102, 103 im Abstand voneinander befestigt.

Der Stift 100 ist vorzugsweise, aber nicht notwendigerweise aus Metall. Beliebige im ausreichenden Maße stabile elektrisch leitende Materialien kommen dabei in Betracht.

Ein massiver Stift kann in Figuren 4, 5 durch ein Metallrohr ersetzt werden.

Die Erfindung ist nicht auf die vorgestellten Ausführungsformen beschränkt. Zur Herstellung eines porösen Körpers des Kontaktelements sowie der dielektrischen Schichten des Grundkörpers des Bauelements können beliebige geeignete Materialien verwendet werden.

Der poröse Körper des Kontaktelements kann, muss aber nicht vorgeformt sein. Es besteht beispielsweise die Möglichkeit, eine für eine vertikale elektrische Verbindung vorgesehene Öffnung in einer dielektrischen Schicht mit einer Füllmasse zu füllen, die neben elektrisch leitenden Partikeln weitere Stoffe enthält, die beim Sintern Gase bilden, was zur Porenbildung in der Füllmasse führt.

Als Elektrodenschichten sind alle bei Sinterbedingungen stabile Metalle bzw. Metalllegierungen geeignet. So kommen insbesondere Elektrodenschichten aus Kupfer oder aus einer Mischung von Silber und Palladium im Gewichtsverhältnis zwischen 90/10 und 70/30 in Betracht.

### Bezugszeichenliste

- 1, 2: Kontaktelement
- 100: Stift
- 101: poröser Körper
- 102, 103: poröser Körper
- 11: poröser Körper
- 12: elektrisch leitfähige Schicht
- 3, 4: Innenelektroden
- 5: dielektrische Lagen
- 6: elektrisch leitende Kappe
- 60: Zuleitung

## Patentansprüche

1. Vielschicht-Bauelement mit mindestens zwei, jeweils durch eine dielektrische Schicht (5) voneinander getrennten Metalllagen, die durch ein Kontaktelement (1, 2) elektrisch miteinander verbunden sind, welches einen porösen Körper (11) enthält, wobei das Kontaktelement (1, 2) stiftförmig ausgebildet ist.

2. Bauelement nach Anspruch 1,
wobei die Porosität des porösen Körpers (11) mehr als 10% seines Volumens beträgt.

3. Bauelement nach Anspruch 1 oder 2,
- bei dem übereinanderliegende dielektrische Schichten (5) und dazwischen liegende Innenelektroden (3, 4) einen Grundkörper bilden und
- bei dem das Kontaktelement (1, 2) senkrecht zu den Innenelektroden (3, 4) verläuft und diese kontaktiert.

4. Bauelement nach einem der Ansprüche 1 bis 3,
bei dem die dielektrischen Schichten (5) jeweils piezoelektrische Eigenschaften aufweisen.

5. Bauelement nach einem der Ansprüche 1 bis 4,
bei dem die dielektrischen Schichten (5) Keramikmaterial enthalten und miteinander versintert sind.

6. Bauelement nach einem der Ansprüche 3 bis 5,
mit übereinander in abwechselnder Reihenfolge angeordneten ersten Innenelektroden (3) und zweiten Innenelektroden (4),
wobei die ersten Innenelektroden (3) jeweils mit einem ersten Kontaktelement (1) kontaktiert und von einem zweiten Kontaktelement (2) isoliert sind,
wobei die zweiten Innenelektroden (4) jeweils mit dem zweiten Kontaktelement (2) kontaktiert und vom ersten Kontaktelement (1) isoliert sind.

7. Bauelement: nach einem der Ansprüche 1 bis 6,
wobei der poröse Körper (11) eine auf dem porösen Körper (11) angeordnete elektrisch leitende Schicht (12) aufweist.

8. Bauelement nach Anspruch 7,
wobei die elektrisch leitende Schicht (12) eine metallische Einbrennpaste ist.

9. Bauelement nach einem der Ansprüche 1 bis 8,
wobei im porösen Körper (11) ein massiver Stift (100) aus einem elektrisch leitenden Material angeordnet ist.

10. Bauelement nach Anspruch 9,
wobei am massiven Stift (100) mehrere übereinander angeordnete und durch einen Luftspalt voneinander getrennte poröse Körper (101, 102, 103) befestigt sind.

11. Bauelement nach einem der Ansprüche 1 bis 10,
wobei an einer Stirnseite des porösen Körpers (11) des Kontaktelements (1, 2) eine Kontaktkappe (6) aus einem elektrisch leitenden Material vorgesehen ist.

12. Bauelement nach Anspruch 11,
wobei das elektrisch leitende Material der Kontaktkappe (6) lötbar ist.

13. Bauelement nach einem der Ansprüche 3 bis 12,
wobei an einer Außenseite des Grundkörpers eine Ausnehmung zur Aufnahme des Kontaktelements (1, 2) ausgebildet ist.

14. Bauelement nach einem der Ansprüche 3 bis 12,
wobei im Grundkörperinneren eine Öffnung zur Aufnahme des Kontaktelements (1, 2) ausgebildet ist.

15. Bauelement nach einem der Ansprüche 1 bis 14,
wobei das Material des porösen Körpers (11) offenporig ist.

16. Bauelement nach einem der Ansprüche 1 bis 15,
wobei das Material des porösen Körpers (11) elektrisch leitend ist.

17. Bauelement nach Anspruch 16,
wobei das Material des porösen Körpers (11) ein Metallschwamm ist.

18. Bauelement nach einem der Ansprüche 1 bis 15,
wobei das Material des porösen Körpers (11) ein anorganisches Material ist.

19. Bauelement nach einem der Ansprüche 1 bis 15 und 18,
wobei das Material des porösen Körpers (11) elektrisch nicht leitfähig ist, und
wobei die Oberfläche des porösen Körpers (11) mit einer elektrisch leitfähigen Schicht (12) versehen ist.

20. Bauelement nach Anspruch 18 oder 19,
wobei das Material des porösen Körpers (11) Keramik enthält.

21. Bauelement nach einem der Ansprüche 1 bis 12 und 16,
wobei das Material des porösen Körpers (11) ein organisches Material ist.

22. Bauelement nach Anspruch 18 oder 21,
wobei die Oberfläche des porösen Körpers (11) mit einer elektrisch leitfähigen Schicht (12) versehen ist.

23. Bauelement nach einem der Ansprüche 3 bis 12 und 14 bis 22, wobei das Kontaktelement (1, 2) im Grundkörperinneren zentrisch angeordnet ist.

24. Bauelement nach Anspruch 23,
wobei das im Grundkörperinneren zentrisch angeordnete Kontaktelement (1, 2) einen Metallstift (100) und mehrere an diesem befestigte und mit dem Metallstift elektrisch verbundene Segmente (101, 102, 103) eines leitfähigen porösen Materials aufweist.

25. Bauelement nach einem der Ansprüche 1 bis 24,
wobei der poröse Körper (11) des Kontaktelements (1, 2) quer zu den Metalllagen verläuft.

## Claims

1. Multilayer component comprising at least two metal layers which are respectively separated from one another by a dielectric layer (5) and which are electrically connected to one another by a contact element (1, 2) containing a porous body (11), wherein the contact element (1, 2) is embodied in pin-type fashion.

2. Component according to Claim 1,
wherein the porosity of the porous body (11) is more than 10% of its volume.

3. Component according to Claim 1 or 2,
- wherein dielectric layers (5) lying one above another and internal electrodes (3, 4) lying between them form a basic body, and
- wherein the contact element (1, 2) runs perpendicularly to the internal electrodes (3, 4) and makes contact therewith.

4. Component according to any of Claims 1 to 3,
wherein the dielectric layers (5) each have piezoelectric properties.

5. Component according to any of Claims 1 to 4,
wherein the dielectric layers (5) contain ceramic material and are sintered to one another.

6. Component according to any of Claims 3 to 5,
comprising first internal electrodes (3) and second internal electrodes (4) arranged one above another in an alternate order, wherein the first internal electrodes (3) are respectively contact-connected to a first contact element (1) and insulated from a second contact element (2), wherein the second internal electrodes (4) are respectively contact-connected to the second contact element (2) and insulated from the first contact element (1).

7. Component according to any of Claims 1 to 6,
wherein the porous body (11) has an electrically conductive layer (12) arranged on the porous body (11).

8. Component according to Claim 7,
wherein the electrically conductive layer (12) is a metallic firing paste.

9. Component according to any of Claims 1 to 8,
wherein a solid pin (100) composed of an electrically conductive material is arranged in the porous body (11).

10. Component according to Claim 9,
wherein a plurality of porous bodies (101, 102, 103) arranged one above another and separated from one another by an air gap are fixed to the solid pin (100).

11. Component according to any of Claims 1 to 10,
wherein a contact cap (6) composed of an electrically conductive material is provided at an end side of the porous body (11) of the contact element (1, 2).

12. Component according to Claim 11,
wherein the electrically conductive material of the contact cap (6) is solderable.

13. Component according to any of Claims 3 to 12,
wherein a cutout for receiving the contact element (1, 2) is formed at an outer side of the basic body.

14. Component according to any of Claims 3 to 12,
wherein an opening for receiving the contact element (1, 2) is formed in the interior of the basic body.

15. Component according to any of Claims 1 to 14,
wherein the material of the porous body (11) is open-pored.

16. Component according to any of Claims 1 to 15,
wherein the material of the porous body (11) is electrically conductive.

17. Component according to Claim 16,
wherein the material of the porous body (11) is a metal sponge.

18. Component according to any of Claims 1 to 15,
wherein the material of the porous body (11) is an inorganic material.

19. Component according to any of Claims 1 to 15 and 18, wherein the material of the porous body (11) is electrically non-conductive, and
wherein the surface of the porous body (11) is provided with an electrically conductive layer (12).

20. Component according to Claim 18 or 19,
wherein the material of the porous body (11) contains ceramic.

21. Component according to any of Claims 1 to 12 and 16,
wherein the material of the porous body (11) is an organic material.

22. Component according to Claim 18 or 21,
wherein the surface of the porous body (11) is provided with an electrically conductive layer (12).

23. Component according to any of Claims 3 to 12, and 14 to 22,
wherein the contact element (1, 2) is arranged centrally in the interior of the basic body.

24. Component according to Claim 23,
wherein the contact element (1, 2) arranged centrally in the interior of the basic body has a metal pin (100) and a plurality of segments (101, 102, 103) of a conductive porous material which are fixed to said metal pin and are electrically connected to the metal pin.

25. Component according to any of Claims 1 to 24,
wherein the porous body (11) of the contact element (1, 2) runs transversely with respect to the metal layers.

## Revendications

1. Composant multicouche comportant au moins deux couches métalliques séparées l'une de l'autre par une couche diélectrique (5) et reliées électriquement l'une à l'autre par un élément de contact (1, 2) qui contient un corps poreux (11), l'élément de contact (1, 2) ayant la forme d'une tige.

2. Composant selon la revendication 1, dans lequel la porosité du corps poreux (11) représente plus de 10 % de son volume.

3. Composant selon les revendications 1 ou 2, dans lequel les couches diélectriques (5) superposées et les électrodes intérieures (3, 4) situées entre elles forment un corps de base et dans lequel l'élément de contact (1, 2) s'étend perpendiculairement aux électrodes intérieures et les met en contact.

4. Composant selon l'une des revendications 1 à 3, dans lequel les couches diélectriques (5) présentent chacune des propriétés piézoélectriques.

5. Composant selon l'une des revendications 1 à 4, dans lequel les couches diélectriques (5) contiennent un matériau céramique et sont frittées les unes aux autres.

6. Composant selon l'une des revendications 3 à 5, présentant des premières électrodes intérieures (3) et des deuxièmes électrodes intérieures (4) superposées en succession alternée, les premières électrodes intérieures (3) étant toutes en contact avec un premier élément de contact (1) et étant isolées d'un deuxième élément de contact (2), les deuxièmes électrodes intérieures (4) étant chacune en contact avec le deuxième élément de contact (2) et étant isolées du premier élément de contact (1).

7. Composant selon l'une des revendications 1 à 6, dans lequel le corps poreux (11) présente une couche électriquement conductrice (12) disposée sur le corps poreux (11).

8. Composant selon la revendication 7, dans lequel la couche électriquement conductrice (12) est une pâte métallique de cuisson.

9. Composant selon l'une des revendications 1 à 8, dans lequel une tige pleine (100) en matériau électriquement conducteur est disposée dans le corps poreux (11).

10. Composant selon la revendication 9, dans lequel plusieurs corps poreux (101, 102, 103) disposés les uns au-dessus des autres et séparés les uns des autres par un interstice d'air sont fixés sur la tige pleine (100).

11. Composant selon l'une des revendications 1 à 10, dans lequel un capuchon de contact (6) en matériau électriquement conducteur est prévu sur un côté frontal du corps poreux (11) de l'élément de contact (1, 2).

12. Composant selon la revendication 11, dans lequel le matériau électriquement conducteur du capuchon de contact (6) peut être brasé.

13. Composant selon l'une des revendications 3 à 12, dans lequel une découpe qui reprend l'élément de contact (1, 2) est ménagée sur un côté extérieur du corps de base.

14. Composant selon l'une des revendications 3 à 12, dans lequel une ouverture de reprise de l'élément de contact (1, 2) est ménagée à l'intérieur du corps de base.

15. Composant selon l'une des revendications 1 à 14, dans lequel le matériau du corps poreux (11) a une porosité ouverte.

16. Composant selon l'une des revendications 1 à 15, dans lequel le matériau du corps poreux (11) est électriquement conducteur.

17. Composant selon la revendication 16, dans lequel le matériau du corps de base (11) est une éponge métallique.

18. Composant selon l'une des revendications 1 à 15, dans lequel le matériau du corps poreux (11) est un matériau minéral.

19. Composant selon l'une des revendications 1 à 15 et 18, dans lequel le matériau du corps poreux (11) n'est pas électriquement conducteur et dans lequel la surface du corps poreux (11) est dotée d'une couche électriquement conductrice (12).

20. Composant selon les revendications 18 ou 19, dans lequel le matériau du corps poreux (11) contient une céramique.

21. Composant selon l'une des revendications 1 à 12 et 16, dans lequel le matériau du corps poreux (11) est un matériau minéral.

22. Composant selon les revendications 18 ou 21, dans lequel la surface du corps poreux (11) est dotée d'une couche électriquement conductrice (12).

23. Composant selon l'une des revendications 3 à 12 et 14 à 22, dans lequel l'élément de contact (1, 2) est disposé au centre à l'intérieur du corps de base.

24. Composant selon la revendication 23, dans lequel l'élément de contact (1, 2) disposé au centre à l'intérieur du corps de base présente une tige métallique (100) et plusieurs segments (101, 102, 103) en un matériau poreux et conducteur, fixés sur la tige métallique et reliés électriquement à cette dernière.

25. Composant selon l'une des revendications 1 à 24, dans lequel le corps poreux (11) de l'élément de contact (1, 2) s'étend transversalement par rapport aux couches métalliques.
